(19) **Europäisches Patentamt / European Patent Office / Office européen des brevets**

(11) **EP 2 916 193 B1**

(12) **FASCICULE DE BREVET EUROPEEN**

(45) Date de publication et mention de la délivrance du brevet:
**27.07.2016 Bulletin 2016/30**

(51) Int Cl.:
*G06F 1/08* *(2006.01)*     *G04G 3/02* *(2006.01)*
*G06F 1/06* *(2006.01)*

(21) Numéro de dépôt: **14158103.3**

(22) Date de dépôt: **06.03.2014**

(54) **BASE DE TEMPS COMPRENANT UN OSCILLATEUR, UN CIRCUIT DIVISEUR DE FRÉQUENCE ET UN CIRCUIT D'INHIBITION D'IMPULSIONS DE CADENCEMENT**

**ZEITBASIS, DIE EINEN OSZILLATOR, EINE FREQUENZTEILERSCHALTUNG UND EINEN SCHALTKREIS ZUR TAKTPULSHEMMUNG UMFASST**

**TIME BASE INCLUDING AN OSCILLATOR, A FREQUENCY-DIVIDER CIRCUIT AND A TIMING PULSE INHIBITION CIRCUIT**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**09.09.2015 Bulletin 2015/37**

(73) Titulaire: **EM Microelectronic-Marin SA 2074 Marin (CH)**

(72) Inventeurs:
• **Godat, Yves 2087 Cornaux (CH)**
• **Jeannet, Nicolas 2019 Chambrelien (CH)**
• **Klopfenstein, François 2800 Delémont (CH)**

(74) Mandataire: **Surmely, Gérard et al ICB Ingénieurs Conseils en Brevets Faubourg de l'Hôpital 3 2001 Neuchâtel (CH)**

(56) Documents cités:
**EP-A1- 0 253 227     EP-A1- 0 999 483**

**Description**

<u>Domaine technique</u>

La présente invention concerne le domaine des bases de temps fournissant un signal d'horloge ou plusieurs signaux d'horloge dont la fréquence, respectivement les fréquences est/sont générée(s) par un circuit diviseur de fréquence recevant en entrée un signal périodique engendré par un oscillateur, notamment un oscillateur à quartz.

<u>Arrière-plan technologique</u>

Il est connu des bases de temps du type mentionné ci-avant dans lesquelles il est prévu un circuit d'ajustement de la fréquence du signal d'horloge ou des fréquences respectives de plusieurs signaux d'horloge prévus. Un tel circuit d'ajustement est généralement formé par un circuit d'inhibition d'impulsions de cadencement dans la chaîne de division, ce circuit d'inhibition étant agencé pour inhiber un certain nombre entier d'impulsions de cadencement à un étage de cette chaîne de division dans chaque période d'inhibition. En général, il est prévu d'inhiber des impulsions de cadencement dans les premiers étages de division pour avoir une meilleure résolution.

Voir, par exemple, EP 999 483 A1 et EP 253 227 A1.

En particulier, il est connu des mouvements horlogers électroniques équipés d'une telle base de temps dans laquelle l'oscillateur à quartz fournit un signal périodique dont la fréquence $F_{osc}$ est légèrement au-dessus d'une fréquence égale à 32'768 Hz (nommé communément signal à 32 kHz). Le circuit diviseur de fréquence est formé par une chaîne de division par deux. On comprend ainsi le choix de la fréquence de l'oscillateur puisque $32'768 = 2^{15}$. Le circuit d'inhibition agit par exemple au niveau du deuxième étage de division, plus exactement en entrée de ce deuxième étage où la fréquence de cadencement correspond à la fréquence $F_{osc}$ de l'oscillateur divisée par deux. On peut ainsi définir une fréquence de référence $F_{ref} = 32'768/2 = 16'384$. Le nombre entier $N_{inh}$ d'impulsions de cadencement à inhiber dans chaque période d'inhibition $P_{inh}$ est généralement obtenu en prenant la valeur entière arrondie de la différence entre $F_{osc}^{det} / 2$ et $F_{ref}$ multipliée par la période d'inhibition $P_{inh}$ prévue, soit l'arrondi à l'unité de $(F_{osc}^{det} / 2 - F_{ref}) \cdot P_{inh}$ où $F_{osc}^{det}$ est la fréquence déterminée pour le signal périodique. Cette détermination de la fréquence est réalisée soit par une mesure initiale, soit par un calcul tenant compte de la température mesurée en utilisant un polynôme prédéfini qui exprime la dépendance de la fréquence de l'oscillateur en fonction de la température. La résolution obtenue est donc donnée par $1/(2 \cdot F_{ref} \cdot P_{inh})$. On comprend ainsi que pour augmenter la résolution et donc la précision de la base de temps à long terme, il faut augmenter la période $P_{inh}$. Il résulte de cette situation un premier problème provenant du fait que l'erreur instantanée maximale augmente proportionnellement à cette période $P_{inh}$. Ce problème peut être crucial dans un test de précision de la base de temps effectué sur une période de test relativement courte, par exemple de quelques heures. De plus, étant donné que l'inhibition est généralement effectuée dans un court intervalle de chaque période $P_{inh}$, un deuxième problème provient du fait que le signal ou les signaux d'horloge est/sont perturbé(s) durant ce court intervalle. Ainsi, dans chaque période d'inhibition, on a un signal avec une fréquence non ajustée et par exemple en fin de la période d'inhibition on inhibe le nombre entier d'impulsions de cadencement prévu, le signal d'horloge cessant alors de fournir un signal périodique durant cette inhibition.

<u>Résumé de l'invention</u>

La présente invention a pour but de résoudre les problèmes de l'art antérieur en fournissant une base de temps ayant une très haute résolution et simultanément une petite erreur instantanée maximale.

A cet effet, la présente invention a pour objet une base de temps telle que revendiquée à la revendication 1, ainsi qu'un procédé d'ajustement de la fréquence d'au moins un signal d'horloge tel que revendiqué à la revendication 8.

<u>Brève description des dessins</u>

L'invention sera décrite ci-après à l'aide de dessins annexés, donnés à titre d'exemples nullement limitatifs, dans lesquels :

- La Figure 1 montre schématiquement une base de temps selon l'invention avec les divers blocs fonctionnels de cette base de temps ; et

- La Figure 2 représente l'architecture du circuit d'ajustement de la fréquence d'au moins un signal d'horloge de la base de temps de la Figure 1.

Description détaillée de l'invention

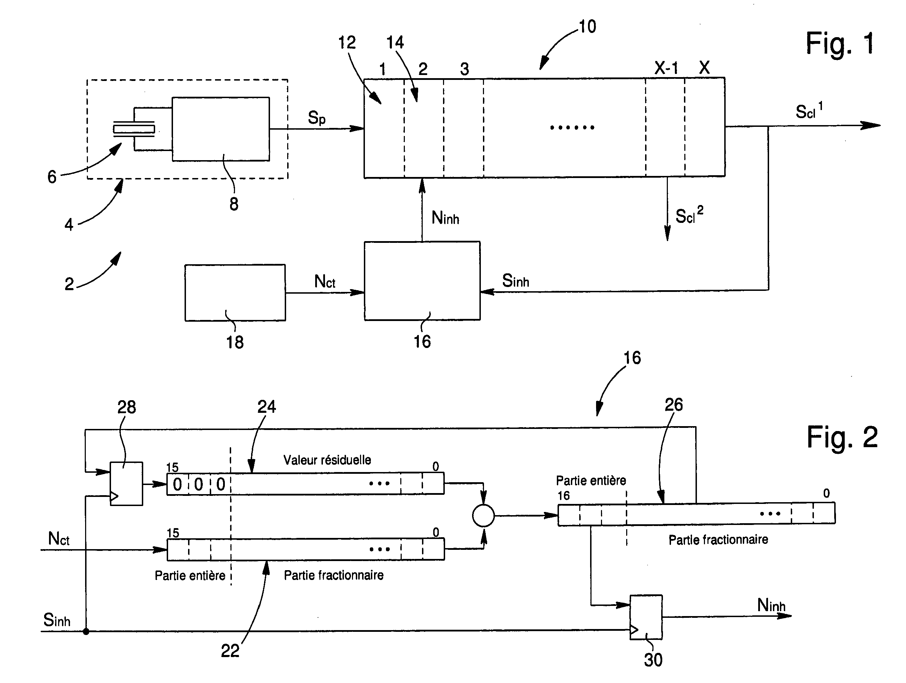

A l'aide des Figures 1 et 2, on décrira ci-après une base de temps selon l'invention. Cette base de temps 2 comprend :

- un oscillateur 4 générant un signal périodique $S_p$ ayant une fréquence propre $F_{osc}$ supérieure à une valeur de référence,

- un circuit diviseur de fréquence 10 formé par une chaîne de division définissant plusieurs étages de division (référencés 1,2,3,...,X-1,X), ce circuit diviseur recevant en entrée le signal périodique $S_p$ et fournissant en sortie au moins un signal d'horloge $S_{cl}^1$ ou $S_{cl}^2$ ayant une fréquence divisée,

- un circuit d'ajustement de la fréquence divisée 16 fonctionnant par inhibition, dans chaque période d'inhibition $P_{inh}$ d'une pluralité de périodes d'inhibition successives, d'un nombre entier $N_{inh}$ d'impulsions de cadencement en entrée d'un étage donné 14 de la chaîne de division.

La base de temps est agencée selon l'invention pour fournir dans chaque période d'inhibition $P_{inh}$ un premier nombre réel $N_{ct}$ correspondant à une période d'inhibition $P_{inh}$ multipliée par la différence entre une fréquence de cadencement $F_{ct}$ déterminée, fournie par l'étage de division précédant l'étage donné 14 ou par l'oscillateur lorsque cet étage donné est le premier étage de la chaîne de division, et une fréquence de référence $F_{ref}$ pour le cadencement de cet étage donné. En d'autres termes, le premier nombre réel $N_{ct}$ est donné par l'expression mathématique suivante :

$$N_{ct} = P_{inh} \cdot (F_{osc}^{det} - F_{osc}^{ref}) / K_{Div} \qquad (1)$$

dans laquelle $F_{osc}^{det}$ est la fréquence déterminée du signal périodique $S_p$ fourni par l'oscillateur 4, $F_{osc}^{ref}$ la valeur de référence pour la fréquence de l'oscillateur, et $K_{Div}$ le coefficient de division entre l'entrée du circuit diviseur de fréquence 10 et l'entrée de l'étage donné de la chaîne de division où est prévu l'inhibition d'impulsions de cadencement. Ainsi, $F_{ct}$ = $F_{osc}^{det}/K_{Div}$ et $F_{ref}$ = $F_{osc}^{ref}/K_{Div}$. Dans une première variante où l'étage donné est le premier étage 12 de la chaîne de division, $K_{Div}$ = 1. Dans une deuxième variante où l'étage donné est le deuxième étage 14 d'une chaîne de division par deux, $K_{Div}$ = 2.

Ensuite, le circuit d'ajustement de la fréquence divisée 16 est agencé pour calculer dans chaque période d'inhibition (n = 1,2,3,...,etc.) un deuxième nombre réel $NB^n$ qui est dans une première période d'inhibition (n = 1) égal au premier nombre réel $N_{ct}$ (donc $NB^1 = N_{ct}$) et ensuite dans chaque période d'inhibition successive égal à l'addition de ce premier nombre réel et de la partie fractionnaire du deuxième nombre réel $NB^{n-1}$ obtenu pour la période d'inhibition précédente. Le nombre entier d'impulsions de cadencement à inhiber dans chaque période d'inhibition est donné par la partie entière du deuxième nombre réel $NB^n$ calculé dans cette période d'inhibition.

Dans la variante représentée à la Figure 1, l'oscillateur 4 est formé par un résonateur à quartz 6 associé à un circuit électronique 8 fournissant un signal périodique digital $S_p$. Le premier nombre réel $N_{ct}$ est fourni par une unité électronique 18, laquelle peut être dans une variante simple formée par une mémoire dans laquelle ce nombre réel est introduit initialement. Dans une variante plus évoluée qui sera exposée par la suite, l'unité électronique 18 est un circuit électronique capable d'effectuer certains calculs ou un microprocesseur.

On remarquera que, à la Figure 1, le signal d'inhibition $N_{inh}$ est fourni au deuxième étage 14 du circuit diviseur de fréquence. Cependant, ceci constitue seulement une variante préférée qui ne limite nullement l'invention. On notera que le signal d'inhibition est référencé par le nombre entier $N_{inh}$ d'impulsions de cadencement inhibées par période d'inhibition, pour simplifier l'exposé de l'invention. On remarquera encore que, à la Figure 1, deux signaux d'horloge $S_{cl}^1$ et $S_{cl}^2$ sont représentés en sortie du circuit diviseur de fréquence, le premier signal d'horloge $S_{cl}^1$ étant fourni en bout de la chaîne de division alors que le deuxième signal d'horloge $S_{cl}^2$ est fourni par l'avant-dernier étage X-1 de cette chaîne de division qui comporte X étages de division. Il s'agit ici que d'un exemple nullement limitatif. En effet, la base de temps peut fournir dans une variante un seul signal d'horloge et dans une autre variante plus de deux signaux d'horloge. De plus, il est possible de prévoir qu'un signal d'horloge soit fourni en sortie de l'un quelconque des étages de division en aval de l'étage de division où l'inhibition est effectuée, et même en sortie de cet étage de division donné.

Dans le cas où la dépendance en température de la fréquence de l'oscillateur n'est pas prise en compte, le premier nombre réel $N_{ct}$ est calculé initialement à l'aide de la formule mathématique (1) donnée ci-avant suite à une mesure de la fréquence $F_{osc}^{det}$ de l'oscillateur. $N_{ct}$ est ensuite introduit dans une mémoire de la base de temps. Dans une variante préférée où la température est mesurée périodiquement par un capteur de température associé à la base de temps, la dépendance en température est donnée notamment par un polynôme du type suivant :

$$N_{ct} = a(T-T_0)^4 + b(T-T_0)^3 + c(T-T_0)^2 + d(T-T_0) + N_{ct}(T_0) \qquad (2)$$

A titre d'exemple, on choisit $T_0 = 20°$. On mesure la fréquence $F_{osc}^{det}$ de l'oscillateur à 20° et on calcule $N_{ct}(20°)$ à l'aide de la formule mathématique (1). Concernant la valeur des paramètres a, b, c et d du polynôme (2), deux solutions sont envisageables : Soit ces paramètres sont déterminés pour un lot d'oscillateurs, sur la base de mesures et/ou de connaissances théoriques ou empiriques du résonateur 6, et sont introduits initialement dans toutes les bases de temps du lot ; soit plusieurs mesures de la fréquence de chaque oscillateur 4 sont effectuées à diverses températures et ainsi ces paramètres sont calculés pour chaque oscillateur et introduits dans chaque base de temps. La température T peut être mesurée à nouveau pour chaque période d'inhibition, mais comme la température évolue normalement lentement et pour économiser l'énergie, la période de mesure de la température T est généralement prévue supérieure à la période d'inhibition.

Selon une variante avec un résonateur à quartz, la valeur de référence $F_{osc}^{ref}$ est égale à 32'768, et la chaîne de division est une chaîne de division par deux. L'étage où est effectuée l'inhibition est le deuxième étage 14 de cette chaîne de division et la fréquence de référence $F_{ref}$ est donc égal à 16'384 Hz.

Selon une autre variante, chaque période d'inhibition $P_{inh}$ a une durée égale à une seconde, cette durée étant définie par un signal d'horloge $S_{inh}$ qui est fourni au circuit d'ajustement 16 par le circuit diviseur de fréquence 10 en aval de l'étage d'inhibition de sa chaîne de division. Si le dernier étage de division X fournit un top seconde, le signal $S_{inh}$ est ici le signal d'horloge $S_{cl}^1$ comme représenté à la Figure 1.

Selon une autre variante, chaque période d'inhibition $P_{inh}$ a une durée égale à une fraction de seconde, cette durée étant définie par un signal d'horloge $S_{inh}$ qui est fourni au circuit d'ajustement 16 par le circuit diviseur de fréquence 10 en aval de l'étage d'inhibition de sa chaîne de division. Dans le cas d'une chaîne de division par deux, la durée sera de préférence égale à $1/2^y$ seconde, y étant un nombre entier supérieur ou égal à un. Ainsi, le signal d'horloge $S_{inh}$ fourni au circuit d'ajustement est directement généré par un étage du circuit diviseur de fréquence fournissant un signal d'horloge ajusté avec une fréquence à $2^y$ Hz.

Selon une variante déjà mentionnée précédemment, la base de temps est agencée pour fournir une pluralité de signaux d'horloge ajustés qui sont générés par les sorties respectives d'une pluralité d'étages de division différents de la chaîne de division du circuit diviseur de fréquence 10, cette pluralité d'étages étant sélectionnée parmi l'étage d'inhibition et les étages de division en aval de cet étage d'inhibition.

Selon un mode de réalisation du circuit d'ajustement 16 représenté à la Figure 2, le premier nombre réel $N_{ct}$ et le deuxième nombre réel défini précédemment sont chargés dans deux registres respectifs 22 et 26. Ces deux registres ont chacun au moins N bits pour leur partie fractionnaire, N étant un nombre entier supérieur à un. On détermine donc le premier nombre réel $N_{ct}$ avec une précision de N chiffres après la virgule. Dans une première variante, le nombre N est supérieur à cinq. Dans une deuxième variante préférée, le nombre N est supérieur ou égal à dix.

Lors de chaque période d'inhibition, la partie entière du deuxième nombre réel qui se trouve dans le registre 26 est fournie via une bascule 30 au circuit diviseur de fréquence qui est agencé pour traiter cette information correctement en inhibant un nombre correspondant d'impulsions de cadencement dans l'étage d'inhibition prévu. La partie fractionnaire du registre 26 est transférée via une bascule 28 dans un registre 24 formant une mémoire tampon. Une fois la partie entière et la partie fractionnaire du registre 26 transférées à la réception du signal d'horloge $S_{inh}$, la valeur résiduelle qui se trouve dans le registre 24 est additionnée au nombre $N_{ct}$ se trouvant dans le registre 22, le résultat de cette addition étant à nouveau introduit dans le registre 26. Au prochain signal d'horloge $S_{inh}$, la partie entière et la partie fractionnaire du registre 26 sont à nouveau transférées comme indiqué ci-avant, et ainsi de suite pour les périodes d'inhibition successives. La partie fractionnaire du nombre réel $N_{ct}$ est donc additionnée dans chaque période d'inhibition au cumul de cette partie fractionnaire dans les périodes d'inhibition précédentes, et chaque fois que ce cumul atteint une valeur supérieure ou égale à un, la partie entière du registre 26 augmente d'une unité. Ainsi, le nombre d'impulsions de cadencement inhibées au prochain signal d'horloge $S_{inh}$ est augmenté d'une unité.

Grâce aux caractéristiques de l'invention, on peut maintenir l'erreur instantanée maximale petite tout en ayant une haute résolution pour le ou les signaux d'horloges fourni(s) par la base de temps car la résolution ne dépend plus seulement de la période d'inhibition, mais également de la grandeur du registre de la partie fractionnaire des premier et deuxième nombres réels. En effet, dans la base de temps selon l'invention, la résolution R est donnée par

$$R = (1/P_{inh}) \cdot (1/F_{ct}) \cdot (1/2^N)$$

où N est le nombre de bits prévu pour la partie fractionnaire des premier et deuxième nombres réels dans les registres respectifs 22 et 26, $F_{ct}$ la fréquence de cadencement de l'étage d'inhibition dans le diviseur de fréquence, et $P_{inh}$ la période d'inhibition. On comprend donc que la résolution peut être ainsi très haute, c'est-à-dire que R est très petit.

La présente invention concerne également un procédé d'ajustement de la fréquence d'au moins un signal d'horloge fourni par une base de temps telle que décrite précédemment. De manière générale, cette base de temps comprend :

- un oscillateur générant un signal périodique ayant une fréquence propre supérieure à une valeur de référence,

- un circuit diviseur de fréquence formé par une chaîne de division définissant plusieurs étages de division, ce circuit diviseur recevant en entrée le signal périodique et fournissant en sortie au moins un signal d'horloge avec une fréquence divisée,

- un circuit d'ajustement de la fréquence divisée par inhibition, dans chaque période d'inhibition d'une pluralité de périodes d'inhibition successives, d'un nombre entier d'impulsions de cadencement en entrée d'un étage donné de la chaîne de division.

Le procédé d'ajustement de la fréquence d'au moins un signal d'horloge selon l'invention comprend les étapes suivantes :

A) fournir dans chaque période d'inhibition $P_{inh}$ un premier nombre réel $N_{ct}$ correspondant à cette période d'inhibition multipliée par la différence entre une fréquence de cadencement déterminée, fournie par l'étage de division précédent ledit étage donné ou par l'oscillateur lorsque cet étage donné est le premier étage de la chaîne de division, et une fréquence de référence pour le cadencement de cet étage donné,

B) calculer dans chaque période d'inhibition un deuxième nombre réel qui est, dans une première période d'inhibition, égal au premier nombre réel $N_{ct}$ et ensuite dans chaque période d'inhibition successive égal à l'addition de ce premier nombre réel et de la partie fractionnaire du deuxième nombre réel obtenu pour la période d'inhibition précédente,

C) inhiber dans chaque période d'inhibition la partie entière du deuxième nombre réel calculé dans cette période d'inhibition.

**Revendications**

**1.** Base de temps (2) comprenant :

- un oscillateur (4) générant un signal périodique ($S_p$) ayant une fréquence propre supérieure à une valeur de référence,
- un circuit diviseur de fréquence (10) formé par une chaîne de division définissant plusieurs étages de division (1 à X), ce circuit diviseur recevant en entrée ledit signal périodique et fournissant en sortie au moins un signal d'horloge ($S_{cl}1$, $S_{cl}2$) ayant une fréquence divisée,
- un circuit d'ajustement de la fréquence divisée (16) par inhibition, dans chaque période d'inhibition d'une pluralité de périodes d'inhibition successives, d'un nombre entier d'impulsions de cadencement ($N_{inh}$) en entrée d'un étage donné de ladite chaîne de division, **caractérisée en ce que** la base de temps est agencée pour fournir dans chaque période d'inhibition un premier nombre réel ($N_{ct}$) correspondant à cette période d'inhibition multipliée par la différence entre une fréquence de cadencement déterminée, fournie par l'étage de division précédant ledit étage donné ou par l'oscillateur lorsque cet étage donné est le premier étage de la chaîne de division, et une fréquence de référence pour le cadencement de cet étage donné ; et **en ce que** le circuit d'ajustement est agencé pour calculer dans chaque période d'inhibition un deuxième nombre réel qui est dans une première période d'inhibition égal audit premier nombre réel et ensuite dans chaque période d'inhibition successive égal à l'addition de ce premier nombre réel et de la partie fractionnaire du deuxième nombre réel obtenu dans la période d'inhibition précédente, ledit nombre entier d'impulsions de cadencement ($N_{inh}$) à inhiber dans chaque période d'inhibition étant donné par la partie entière dudit deuxième nombre réel calculé dans cette période d'inhibition.

**2.** Base de temps selon la revendication 1, **caractérisée en ce que** ladite valeur de référence est 32'768, et **en ce que** ladite chaîne de division est une chaîne de division par deux, ledit étage donné étant le deuxième étage de cette chaîne de division et ladite fréquence de référence étant égale à 16'384 Hz.

3. Base de temps selon la revendication 1 ou 2, **caractérisée en ce que** chaque période d'inhibition a une durée égale à une seconde, cette durée étant définie par un signal d'horloge ($S_{inh}$) fourni par la base de temps en aval dudit étage donné.

4. Base de temps selon la revendication 1 ou 2, **caractérisée en ce que** chaque période d'inhibition a une durée égale à une fraction de seconde, cette durée étant définie par un signal d'horloge fourni par la base de temps en aval dudit étage donné.

5. Base de temps selon l'une quelconque des revendications précédentes, **caractérisée en ce que** cette base de temps est agencée pour fournir une pluralité de signaux d'horloge ajustés qui sont générés par les sorties respectives d'une pluralité d'étages de division différents de ladite chaîne de division parmi ledit étage donné et les étages de division en aval de cet étage donné.

6. Base de temps selon l'une quelconque des revendications précédentes, **caractérisée en ce que** ledit premier nombre réel ($N_{ct}$) et ledit deuxième nombre réel sont chargés dans deux registres respectifs (22, 26) ayant chacun au moins N bits pour leur partie fractionnaire, le premier nombre réel étant déterminé avec une précision de N chiffres après la virgule ; et **en ce que** le nombre N est supérieur à cinq.

7. Base de temps selon l'une quelconque des revendications 1 à 5, **caractérisée en ce que** ledit premier nombre réel ($N_{ct}$) et ledit deuxième nombre réel sont chargés dans deux registres respectifs ayant chacun au moins N bits pour leur partie fractionnaire, le premier nombre réel étant déterminé avec une précision de N chiffres après la virgule ; et **en ce que** le nombre N est supérieur ou égal à dix.

8. Procédé d'ajustement de la fréquence d'au moins un signal d'horloge fourni par une base de temps (2) comprenant :

   - un oscillateur (4) générant un signal périodique ayant une fréquence propre supérieure à une valeur de référence,
   - un circuit diviseur de fréquence (10) formé par une chaîne de division définissant plusieurs étages de division, ce circuit diviseur recevant en entrée ledit signal périodique et fournissant en sortie ledit au moins un signal d'horloge avec une fréquence divisée,
   - un circuit d'ajustement de la fréquence divisée (16) par inhibition, dans chaque période d'inhibition d'une pluralité de périodes d'inhibition successives, d'un nombre entier d'impulsions de cadencement en entrée d'un étage donné de ladite chaîne de division,

   ce procédé d'ajustement de la fréquence d'au moins un signal d'horloge étant **caractérisé en ce qu'**il comprend les étapes suivantes :

   A) fournir dans chaque période d'inhibition un premier nombre réel correspondant à cette période d'inhibition multipliée par la différence entre une fréquence déterminée de cadencement, fournie par l'étage de division précédant ledit étage donné ou par l'oscillateur lorsque cet étage donné est le premier étage de la chaîne de division, et une fréquence de référence pour le cadencement de cet étage donné,
   B) calculer dans chaque période d'inhibition un deuxième nombre réel qui est, dans une première période d'inhibition, égal audit premier nombre réel et ensuite dans chaque période d'inhibition successive égal à l'addition de ce premier nombre réel et de la partie fractionnaire du deuxième nombre réel obtenu pour la période d'inhibition précédente,
   C) inhiber dans chaque période d'inhibition la partie entière dudit deuxième nombre réel calculé dans cette période d'inhibition.

9. Procédé selon la revendication 8, **caractérisé en ce que** ladite valeur de référence est 32'768, et **en ce que** ladite chaîne de division est une chaîne de division par deux, ledit étage donné étant le deuxième étage de cette chaîne de division et ladite fréquence de référence étant égal à 16'384 Hz.

10. Procédé selon la revendication 8 ou 9, **caractérisé en ce que** chaque période d'inhibition a une durée égale à une seconde, cette durée étant définie par un signal d'horloge fourni par la base de temps en aval dudit étage donné.

11. Procédé selon la revendication 8 ou 9, **caractérisé en ce que** chaque période d'inhibition a une durée égale à une fraction de seconde, cette durée étant définie par un signal d'horloge fourni par la base de temps en aval dudit étage donné.

**12.** Procédé selon l'une quelconque des revendications 8 à 11, **caractérisé en ce que** cette base de temps est agencée pour fournir une pluralité de signaux d'horloge ajustés qui sont générés par les sorties d'une pluralité d'étages de division différents de ladite chaîne de division parmi ledit étage donné et les étages de division en aval de cet étage donné.

**13.** Procédé selon l'une quelconque des revendications 8 à 12, **caractérisé en ce que** ledit premier nombre réel et ledit deuxième nombre réel sont chargés dans deux registres respectifs ayant chacun au moins N bits pour leur partie fractionnaire, le premier nombre réel étant déterminé avec une précision de N chiffres après la virgule ; et **en ce que** le nombre N est supérieur à cinq.

**14.** Procédé selon l'une quelconque des revendications 8 à 12, **caractérisé en ce que** ledit premier nombre réel et ledit deuxième nombre réel sont chargés dans deux registres respectifs ayant chacun au moins N bits pour leur partie fractionnaire, le premier nombre réel étant déterminé avec une précision de N chiffres après la virgule ; et **en ce que** le nombre N est supérieur ou égal à dix.

## Patentansprüche

**1.** Zeitbasis (2), umfassend:

einen Oszillator (4), der ein periodisches Signal ($S_p$) erzeugt, das eine Eigenfrequenz hat, die höher ist als ein Referenzwert,

- einen Frequenzteiler (10), der von einer Teilerkette gebildet ist, die mehrere Teilerstufen (1 bis X) definiert, wobei dieser Teilerkreis am Eingang das periodische Signal empfängt und am Ausgang wenigstens ein Taktsignal ($S_{cl}^1$, $S_{cl}^2$) mit einer geteilten Frequenz liefert,
- einen Schaltkreis (16) zum Einstellen der geteilten Frequenz durch Hemmung, in jeder Hemmungsperiode einer Vielzahl von aufeinanderfolgenden Hemmungsperioden, einer Ganzzahl von Taktimpulsen ($N_{inh}$) am Eingang einer bestimmten Stufe der Teilerkette, **dadurch gekennzeichnet, dass** die Zeitbasis derart beschaffen ist, dass sie in jeder Hemmungsperiode eine erste reelle Zahl ($N_{ct}$) liefert, die dieser Hemmungsperiode, multipliziert mit der Differenz zwischen einer vorbestimmten Taktfrequenz, die von der der bestimmten Stufe vorhergehenden Teilerstufe oder vom Oszillator, wenn diese bestimmte Stufe die erste Stufe der Teilerkette ist, geliefert wird, und einer Referenzfrequenz für den Takt dieser bestimmten Stufe entspricht; und dass der Einstellkreis derart beschaffen ist, dass er in jeder Hemmungsperiode eine zweite reelle Zahl berechnet, die in einer ersten Hemmungsperiode gleich der ersten reellen Zahl ist und dann in jeder aufeinanderfolgenden Hemmungsperiode gleich der Addition dieser ersten reellen Zahl und der Stellen hinter dem Komma der zweiten in der vorhergehenden Hemmungsperiode erhaltenen reellen Zahl ist, wobei die Ganzzahl von Taktimpulsen ($N_{inh}$), die in jeder Hemmungsperiode gehemmt werden müssen, durch die Stellen vor dem Komma der zweiten in dieser Hemmungsperiode berechneten reellen Zahl gegeben ist.

**2.** Zeitbasis nach Anspruch 1, **dadurch gekennzeichnet, dass** der Referenzwert 32'768 ist und dass die Teilerkette eine Teilerkette mit Teilung durch zwei ist, wobei die bestimmte Stufe die zweite Stufe dieser Teilerkette ist und die Referenzfrequenz gleich 16'384 Hz ist.

**3.** Zeitbasis nach Anspruch 1 oder 2, **dadurch gekennzeichnet, dass** jede Hemmungsperiode eine Dauer gleich einer Sekunde hat, wobei diese Dauer durch ein Taktsignal ($S_{inh}$) definiert ist, das von der Zeitbasis im Anschluss an die bestimmte Stufe geliefert wird.

**4.** Zeitbasis nach Anspruch 1 oder 2, **dadurch gekennzeichnet, dass** jede Hemmungsperiode eine Dauer gleich einem Bruchteil einer Sekunde hat, wobei diese Dauer durch ein Taktsignal definiert ist, das von der Zeitbasis im Anschluss an die bestimmte Stufe geliefert wird.

**5.** Zeitbasis nach einem der vorhergehenden Ansprüche, **dadurch gekennzeichnet, dass** diese Zeitbasis derart beschaffen ist, dass sie eine Vielzahl von eingestellten Taktsignalen liefert, die von den jeweiligen Ausgängen einer Vielzahl von verschiedenen Teilerstufen der Teilerkette unter der bestimmten Stufe und den Teilerstufen im Anschluss an diese bestimmte Stufe erzeugt werden.

**6.** Zeitbasis nach einem der vorhergehenden Ansprüche, **dadurch gekennzeichnet, dass** die erste reelle Zahl ($N_{ct}$) und die zweite reelle Zahl in zwei jeweilige Register (22, 26) geladen werden, wovon jedes wenigstens N Bits für ihre Stellen hinter dem Komma aufweist, wobei die erste reelle Zahl mit einer Präzision von N Ziffern nach dem Komma bestimmt ist; und dass die Zahl N grösser als fünf ist.

**7.** Zeitbasis nach einem der Ansprüche 1 bis 5, **dadurch gekennzeichnet, dass** die erste reelle Zahl ($N_{ct}$) und die zweite reelle Zahl in zwei jeweilige Register geladen werden, wovon jedes wenigstens N Bits für ihre Stellen hinter dem Komma aufweist, wobei die erste reelle Zahl mit einer Präzision von N Ziffern nach dem Komma bestimmt ist; und dass die Zahl N grösser oder gleich zehn ist.

**8.** Verfahren zum Einstellen der Frequenz wenigstens eines Taktsignals, das von einer Zeitbasis (2) geliefert wird, die folgende Elemente umfasst:

- einen Oszillator (4), der ein periodisches Signal erzeugt, das eine Eigenfrequenz hat, die höher ist als ein Referenzwert,
- einen Frequenzteiler (10), der von einer Teilerkette gebildet ist, die mehrere Teilerstufen definiert, wobei dieser Teilerkreis am Eingang das periodische Signal empfängt und am Ausgang wenigstens ein Taktsignal mit einer geteilten Frequenz liefert,
- einen Schaltkreis (16) zum Einstellen der geteilten Frequenz durch Hemmung, in jeder Hemmungsperiode einer Vielzahl von aufeinanderfolgenden Hemmungsperioden, einer Ganzzahl von Taktimpulsen am Eingang einer bestimmten Stufe der Teilerkette,

wobei dieses Verfahren zum Einstellen der Frequenz wenigstens eines Taktsignals **dadurch gekennzeichnet ist, dass** es folgende Schritte umfasst:

A) Liefern, in jeder Hemmungsperiode, einer ersten reellen Zahl, die dieser Hemmungsperiode, multipliziert mit der Differenz zwischen einer vorbestimmten Taktfrequenz, die von der der bestimmten Stufe vorhergehenden Teilerstufe oder vom Oszillator, wenn diese bestimmte Stufe die erste Stufe der Teilerkette ist, geliefert wird, und einer Referenzfrequenz für den Takt dieser bestimmten Stufe entspricht,
B) Berechnen, in jeder Hemmungsperiode, einer zweiten reellen Zahl, die in einer ersten Hemmungsperiode gleich der ersten reellen Zahl ist und dann in jeder aufeinanderfolgenden Hemmungsperiode gleich der Addition dieser ersten reellen Zahl und der Stellen hinter dem Komma der zweiten für die vorhergehende Hemmungsperiode erhaltenen reellen Zahl ist,
C) Hemmen, in jeder Hemmungsperiode, der Stellen vor dem Komma der zweiten in dieser Hemmungsperiode berechneten reellen Zahl.

**9.** Verfahren nach Anspruch 8, **dadurch gekennzeichnet, dass** der Referenzwert 32'768 ist und dass die Teilerkette eine Teilerkette mit Teilung durch zwei ist, wobei die bestimmte Stufe die zweite Stufe dieser Teilerkette ist und die Referenzfrequenz gleich 16'384 Hz ist.

**10.** Verfahren nach Anspruch 8 oder 9, **dadurch gekennzeichnet, dass** jede Hemmungsperiode eine Dauer gleich einer Sekunde hat, wobei diese Dauer durch ein Taktsignal definiert ist, das von der Zeitbasis im Anschluss an die bestimmte Stufe geliefert wird.

**11.** Verfahren nach Anspruch 8 oder 9, **dadurch gekennzeichnet, dass** jede Hemmungsperiode eine Dauer gleich einem Bruchteil einer Sekunde hat, wobei diese Dauer durch ein Taktsignal definiert ist, das von der Zeitbasis im Anschluss an die bestimmte Stufe geliefert wird.

**12.** Verfahren nach einem der Ansprüche 8 bis 11, **dadurch gekennzeichnet, dass** diese Zeitbasis derart beschaffen ist, dass sie eine Vielzahl von eingestellten Taktsignalen liefert, die von den Ausgängen einer Vielzahl von verschiedenen Teilerstufen der Teilerkette unter der bestimmten Stufe und den Teilerstufen im Anschluss an diese bestimmte Stufe erzeugt werden.

**13.** Verfahren nach einem der Ansprüche 8 bis 12, **dadurch gekennzeichnet, dass** die erste reelle Zahl und die zweite reelle Zahl in zwei jeweilige Register geladen werden, wovon jedes wenigstens N Bits für seine Stellen hinter dem Komma aufweist, wobei die erste reelle Zahl mit einer Präzision von N Ziffern nach dem Komma bestimmt ist; und dass die Zahl N grösser als fünf ist.

**14.** Verfahren nach einem der Ansprüche 8 bis 12, **dadurch gekennzeichnet, dass** die erste reelle Zahl und die zweite reelle Zahl in zwei jeweilige Register geladen werden, wovon jedes wenigstens N Bits für seine Stellen hinter dem Komma aufweist, wobei die erste reelle Zahl mit einer Präzision von N Ziffern nach dem Komma bestimmt ist; und dass die Zahl N grösser ist als zehn oder gleich zehn ist.

**Claims**

1. Time base (2) including:

   - an oscillator (4) generating a periodic signal (Sp) having a natural frequency higher than a reference value,
   - a frequency divider circuit (10) formed by a division chain defining several division stages (1 to X), said divider circuit receiving, at input, said periodic signal and delivering, at output, at least one clock signal ($S_{cl}^1 S_{cl}^2$) having a divided frequency,
   - a divided frequency adjustment circuit (16) functioning by inhibiting, in each inhibition period of a plurality of successive inhibition periods, an integer number of clocking pulses ($N_{inh}$) at the input of a given stage of said division chain,
   **characterized in that** the time base is arranged to produce, in each inhibition period, a first real number (Net) corresponding to said inhibition period multiplied by the difference between a determined clocking frequency, produced by the division stage preceding said given stage or by the oscillator when said given stage is the first stage of the division chain, and a reference frequency for clocking said given stage, and **in that** the adjustment circuit is arranged to calculate, in each inhibition period, a second real number, which, in a first inhibition period, is equal to said first real number and then, in each subsequent inhibition period, is equal to the addition of said first real number and the fractional part of the second real number obtained in the preceding inhibition period, said integer number of clocking pulses ($N_{inh}$) to be inhibited in each inhibition period being given by the integer part of said second real number calculated in said inhibition period.

2. Time base according to claim 1, **characterized in that** said reference value is 32.768, and **in that** said division chain is a division-by-two chain, said given stage being the second stage of said division chain and said reference frequency being equal to 16.384 Hz.

3. Time base according to claim 1 or 2, **characterized in that** each inhibition period has a duration equal to one second, said duration being defined by a clock signal ($S_{inh}$) delivered by the time base downstream of said given stage.

4. Time base according to claim 1 or 2, **characterized in that** each inhibition period has a duration equal to a fraction of a second, said duration being defined by a clock signal delivered by the time base downstream of said given stage.

5. Time base according to any of the preceding claims, **characterized in that** said time base is arranged to deliver a plurality of adjusted clock signals which are generated by the respective outputs of a plurality of division stages different from said division chain from among said given stage and the division stages downstream of said given stage.

6. Time base according to any of the preceding claims, **characterized in that** said first real number ($N_{ct}$) and said second real number are loaded in two respective registers (22, 26) each having at least N bits for the fractional part thereof, the first real number being determined with a precision of N numbers after the point; and **in that** the number N is greater than five.

7. Time base according to any of claims 1 to 5, **characterized in that** said first real number ($N_{ct}$) and said second real number are loaded in two respective registers each having at least N bits for the fractional part thereof, the first real number being determined with a precision of N numbers after the point; and **in that** the number N is greater than or equal to ten.

8. Method for adjusting the frequency of at least one clock signal produced by a time base (2) including:

   - an oscillator (4) generating a periodic signal having a natural frequency higher than a reference value,
   - a frequency divider circuit (10) formed by a division chain defining several division stages, said divider circuit receiving, at input, said periodic signal and delivering, at output, said at least one clock signal with a divided frequency,
   - a divided frequency adjustment circuit (16) functioning by inhibiting, in each inhibition period of a plurality of successive inhibition periods, an integer number of clocking pulses at the input of a given stage of said division chain.

said method for adjusting the frequency of at least one clock signal being **characterized in that** the method includes the following steps:

A) providing, in each inhibition period, a first real number corresponding to said inhibition period multiplied by the difference between a determined clocking frequency, produced by the division stage preceding said given stage or by the oscillator when said given stage is the first stage of the division chain, and a reference frequency for clocking said given stage,

B) calculating, in each inhibition period, a second real number which, in a first inhibition period, is equal to said first real number and then in each subsequent inhibition period, is equal to the addition of said first real number and the fractional part of the second real number obtained for the preceding inhibition period,

C) inhibiting, in each inhibition period, the integer part of said second real number calculated in said inhibition period.

9. Method according to claim 8, **characterized in that** said reference value is 32.768, and **in that** said division chain is a division-by-two chain, said given stage being the second stage of said division chain and said reference frequency being equal to 16.384 Hz.

10. Method according to claim 8 or 9, **characterized in that** each inhibition period has a duration equal to one second, said duration being defined by a clock signal delivered by the time base downstream of said given stage.

11. Method according to claim 8 or 9, **characterized in that** each inhibition period has a duration equal to a fraction of a second, said duration being defined by a clock signal delivered by the time base downstream of said given stage.

12. Method according to any of claims 8 to 11, **characterized in that** said time base is arranged to deliver a plurality of adjusted clock signals which are generated by the outputs of a plurality of division stages different from said division stage from among said given stage and the division stages downstream of said given stage.

13. Method according to any of claims 8 to 12, **characterized in that** said first real number and said second real number are loaded in two respective registers each having at least N bits for the fractional part thereof, the first real number being determined with a precision of N numbers after the point; and **in that** the number N is greater than or equal to five.

14. Method according to any of claims 8 to 12, **characterized in that** said first real number and said second real number are loaded in two respective registers each having at least N bits for the fractional part thereof, the first real number being determined with a precision of N numbers after the point; and **in that** the number N is greater than or equal to ten.

Fig. 1

Fig. 2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 999483 A1

- EP 253227 A1